Europäisches Patentamt

European Patent Office

Office européen des brevets

(19)

(11) Publication number: **0 088 477**
**B1**

(12) **EUROPEAN PATENT SPECIFICATION**

(45) Date of publication of patent specification: **22.06.88**

(51) Int. Cl.⁴: **G 05 F 3/20**

(21) Application number: **83200302.4**

(22) Date of filing: **01.03.83**

(54) Current-discrimination arangement.

(30) Priority: **10.03.82 NL 8200974**

(43) Date of publication of application:
**14.09.83 Bulletin 83/37**

(45) Publication of the grant of the patent:
**22.06.88 Bulletin 88/25**

(84) Designated Contracting States:
**DE FR GB IT SE**

(56) References cited:
**US-A-3 930 172**
**US-A-4 282 477**

(73) Proprietor: **N.V. Philips' Gloeilampenfabrieken**
**Groenewoudseweg 1**
**NL-5621 BA Eindhoven (NL)**

(72) Inventor: **Kasperkovitz, Wolfdietrich Georg**
**INT. OCTROOIBUREAU B.V. Prof. Holstlaan 6**
**NL-5656 AA Eindhoven (NL)**

(74) Representative: **Peters, Rudolf Johannes et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a current-discrimination arrangement having an input for receiving a current to be discriminated and an output.

Such a current-discrimination arrangement may be used *inter alia* in current stabilizers but also in, for example, signal-level detectors.

In current stabilizers of the so-called "band-gap reference" type, as described *inter alia* in US—A—3,887,863, such a current discrimination arrangement comprises two current paths, a semiconductor junction in one path being shunted by a semiconductor junction connected in series with a resistor in the other path. The currents in the two paths are compared by means of a resistor and a differential amplifier or by means of a current mirror—which comparison constitutes the discrimination function—and are controlled in such a way that the current densities in the two semiconductor junctions are in a ratio of 1:n, which factor $n \neq 1$ if the two semiconductor junctions are unequal or if the currents in the two paths are made unequal. The current is then stabilized at a value equal to

$$\frac{KT}{qr}\ln n,$$

where K is Boltzmann's constant, T the absolute temperature in °K, q the elementary charge, R the value of said resistor, and ln n the natural logarithm of the factor n. In this type of stabilizer the current is stabilized at a value determined by the factor n. The steepness of the current discrimination is also determined by the factor n. The stabilization improves as the factor n deviates further from unity, but the circuit arrangement then becomes more asymmetrical, which is generally a disadvantage.

"Another current stabilizer of the so-called "bandgap reference type is known from US—A—3.930.172 and also has two current paths, the first path comprising the series arrangement of a diode connected first transistor and a second transistor, the second current path comprising the series arrangement of a third transistor and a fourth transistor connected in series with a resistor. The two current path are coupled in that the bases of the first and the third transistor are interconnected and in that the collectors of the second and the fourth transistor are cross-coupled. When a current is impressed upon the first current path and the current densities of the second and the fourth transistor are in a ratio of 1:n, a stabilized current of a value equal to

$$\frac{kT}{qR}\ln n$$

will flow in the second current path, which current is largely independent on the current flowing in the first current path."

It is the object of the invention to provide a current discrimination arrangement, which has a sharp discrimination characteristic, which is of a highly symmetrical circuit design, and which also discriminates around a value which is proportional to

$$\frac{kT}{q}.$$

To this end the invention is characterized in that the current discrimination arrangement comprises a first transistor and a second transistor, each having a base electrode, an emitter electrode, and a collector electrode, the collector electrode of the first transistor being connected to a first point *via* a first resistor and the collector electrode of the second transistor being connected to said first point *via* a second resistor of substantially the same value as the first resistor, the base electrode of the first transistor being connected to a point between the second resistor and the collector electrode of the second transistor, and the base electrode of the second transistor to a point between the first resistor and the collector electrode of the first transistor, the emitter electrodes of the first and second transistors being connected to a second point, the circuit between the first point and the second point being arranged in series with the input to receive the current to be discriminated, and the output being coupled to at least one of the two collector electrodes to provide an output voltage which as a function of the input current of the arrangement, exhibits a steep transition when the arrangement reaches a bistable condition in which either the first or the second transistor is turned off.

In such a circuit arrangement the input current is distributed equally between the two collector-emitter circuits. As soon as the current has increased so far that the loop gain (from the base to the collector electrode) has become unity, the circuit becomes bistable, which is very easy to detect. The bistable condition is attended by a very steep characteristic: only a very small current increase will turn off one of the two transistors. This point where the circuit arrangement becomes bistable is reached for an input current equal to

$$2\frac{KT}{qR},$$

where R is the value of the first resistor and the second resistor. In this respect it is advantageous if the output is a differential output between the collector electrodes of the first and second transistors. This results in a more strongly varying signal.

When the point is reached where the circuit arrangement becomes bistable, the circuit may assume either of two stable states. However, the circuit arrangement may be adapted so that the output signal is independent of which of the two states the circuit assumes. Suitably, however, there are provided means for defining a preferred state of conduction for the two transistors in the input-current range for which the cross-coupled first and second transistors form a bistable circuit, in such a way that when said bistable condition is reached the first transistor becomes more conductive and the second transistor is cut off.

A preferred embodiment of the discrimination arrangement may be characterized in that a third resistor is arranged between the collector electrode of the first transistor and the connection between the base electrode of the second transistor and the first resistor, a fourth resistor whose resistance value is higher than the resistance of the third resistor is arranged between the collector electrode of the second transistor and the connection between the base electrode of the first transistor and the second resistor and the input of a differential amplifier is connected to the connections between said third and fourth resistors and the collector electrodes of the first and second transistors. As a result of this, the point where the differential amplifier is balanced—which point is more or less the centre of the discrimination characteristic of the current-discrimination arrangement including the differential amplifier—is shifted from the boundary of the steep portion of the discrimination characteristic of the actual current discriminator to a point nearer the centre of this steep portion, which for example provides better control in a current stabilizer. The last-mentioned preferred embodiment may be further characterized in that the differential amplifier comprises a third transistor and a fourth transistor with common emitter electrodes, the collector electrode of the third transistor being connected substantially directly to the first point and the collector electrode of the fourth transistor being connected to the base electrode of a fifth transistor whose emitter electrode is also connected to the first point, the base electrode of the third transistor being connected to the collector electrode of the second transistor, and the base electrode of the fourth transistor being connected to the collector electrode of the first transistor. Since, as a result of the base-emitter junction of the fifth transistor, the collector-base voltage of the fourth transistor for a small input current of the discrimination arrangement is substantially opposite and equal to one base-emitter voltage (of the fifth transistor) and since that of the third transistor is substantially zero volts, the base current of the fourth transistor will be greater than that of the third transistor, so that as a result of these base currents, which flow via the first resistor and the second resistor, the base of the first transistor has a higher bias than the base of the second transistor, so that the second transistor will always be cut-off when the bistable condition is reached.

The invention will now be described in more detail, by way of example, with reference to the drawing, in which,

Figure 1 shows a current discrimination arrangement in accordance with the invention,

Figure 2 shows some characteristics illustrating the operation of the arrangement shown in Figure 1, and

Figure 3 shows a preferred current discriminator in accordance with the invention used in a voltage-reference source.

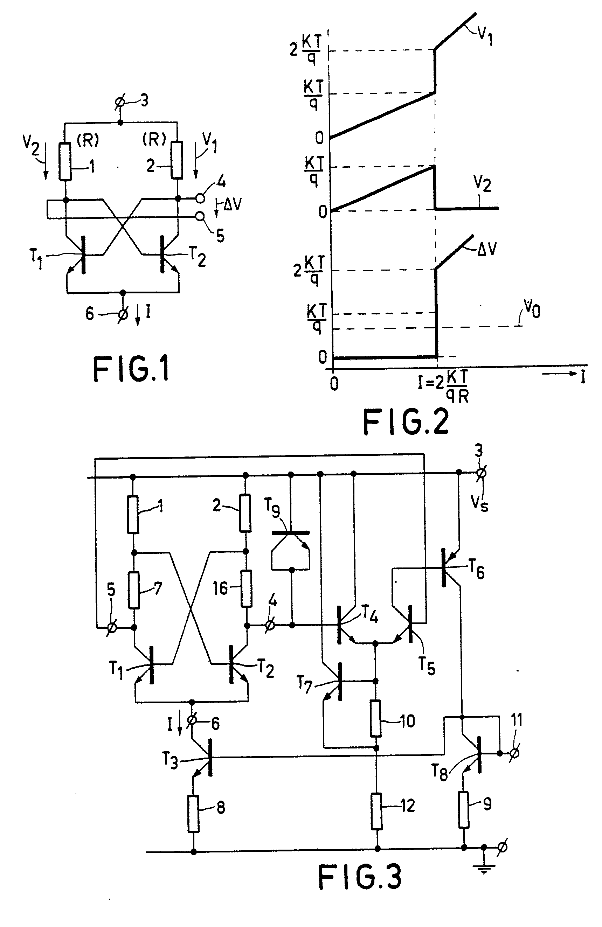

Figure 1 shows a current discrimination arrangement in accordance with the invention. The arrangement comprises a transistor $T_1$, whose emitter electrode is connected to a terminal 6 and whose collector electrode is connected to a terminal 3 *via* a resistor 1, and a transistor $T_2$ whose emitter electrode is connected to the terminal 6 and whose collector electrode is connected to the terminal 3 *via* a resistor 2. The base of transistor $T_1$ is connected to the collector of transistor $T_2$ and to an output terminal 4, and the base of transistor $T_2$ is connected to the collector of transistor $T_1$ and to an output terminal 5.

If a current I flows through the circuit between terminals 3 and 6—as a result of current drive on terminal 3 or 6—$V_1$ in Figure 2 will be the voltage across the resistor 2, $V_2$ the voltage across the resistor 1, and $\Delta V$ the voltage between the output terminals 4 and 5. For small currents I the currents through the transistors $T_1$ and $T_2$ are equal and the voltages $V_1$ and $V_2$ are directly proportional to the current I, the difference voltage $\Delta V$ being zero. For a specific value of the current I, for which value the loop gain in the cross-coupling between the two transistors is unity, the circuit arrangement shown in Figure 1 becomes bistable. This happens when the current I has reached the value

$$2\frac{KT}{qR}.$$

At this instant one of the two transistors $T_1$ and $T_2$ will draw the full current I.

It is assumed in Figure 2 that transistor $T_2$ draws the full current I, as a result of which the voltage $V_1$ of

$$\frac{kT}{q}$$

is doubled so that

$$V_1 = 2\frac{KT}{q}V$$

the voltage $V_2$ becomes zero, and the difference voltage $\Delta V$ becomes

$$2\frac{KT}{q}.$$

At the current

$$I=2\frac{KT}{qR}$$

at which the circuit becomes bistable $V_1$, $V_2$ and $\Delta V$ will vary as a function of the current I in accordance with a very steep characteristic. This portion of the characteristic is therefore eminently suitable as a discrimination characteristic. The voltages $V_1$ and $V_2$ and the difference voltage $\Delta V$ may be used for this purpose, the voltage $\Delta V$ available on the differential output (4, 5) being the most favourable choice in most cases. When the voltage $\Delta V$ is used as the discrimination voltage it is advantageous if this voltage is given approximately a value $V_1$ (Figure 2), for example by introducing an offset $V_0$ in a differential amplifier which amplifies the voltage $\Delta V$, or by applying, for example, a level shift equal to $V_1$ in series with one of the two output terminals 4 and 5.

At the instant that the circuit arrangement shown in Figure 1 becomes bistable it is not predictable which of the two transistors $T_1$ and $T_2$ will carry the current I. This need not present any problem. For example, a circuit may be added to output 4, 5, which circuit amplifies the voltage $\Delta V$ in polarity-independent manner, so that the bistable state of conduction is irrelevant. In order to simplify the circuit arrangement, however, it will be more advantageous to define the condition of the circuit arrangement after it has become bistable. This may be achieved in various ways *inter alia* by making the two transistors or the two collector loads slightly unequal or by applying an additional current to the collector circuit of one of the two transistors.

Figure 3 shows an example of the circuit arrangement shown in Figure 1 used in a current or voltage stabilizing circuit. A current I is applied to the terminal 6 by means of a current-source transistor $T_3$ provided with an emitter resistor 8, terminal 3 being connected to a positive supply voltage VS. The output terminals 4 and 5 are connected to the base electrodes of two transistors $T_4$ and $T_5$, which are arranged as a differential amplifier whose common-emitter line includes a current source comprising the resistors 10 and 11 and a transistor $T_7$. The collector of transistor $T_4$ is connected directly to the power-supply terminal 3, whilst the collector of transistor $T_5$ is connected to the base of pnp-transistor $T_6$, whose emitter electrode is connected to the positive supply-terminal 3. The base electrodes of transistors $T_4$ and $T_5$ are connected to the power supply terminal 3 *via* the collector resistors of transistors $T_1$ and $T_2$. As the base-emitter junction of transistor $T_6$ reduces the collector voltage of transistor $T_5$ in comparison with the collector voltage of transistor $T_4$, the associated base electrodes being connected to the power-supply terminal 3 *via* the collector resistors of transistors $T_1$ and $T_2$, across which resistors a small voltage drop occurs, the base current of transistor $T_5$ is larger than that of transistor $T_4$, which effect is further enhanced because, as will be explained,

transistor $T_5$ carries more current than transistor $T_4$ at the instant that the current discrimination arrangement becomes bistable. As a result of this inequality of the base currents, which base currents flow *via* the resistors 1 and 2, the base of transistor $T_1$ is biased to a higher voltage than the base of transistor $T_2$, so that transistor $T_2$ will be cut off when the current discrimination arrangement becomes bistable.

If the current I is smaller than

$$2\frac{KT}{qR},$$

both transistor $T_1$ and transistor $T_2$ will conduct. Transistor $T_5$ is conductive and drives transistor $T_6$. At the bistable instant when

$$I=2\frac{KT}{qR}$$

transistor $T_2$ is turned off very hard, so that transistor $T_4$ is driven into full conduction and transistor $T_5$ and transistor $T_6$ are cut off. This means that for

$$I=\frac{2KT}{qR}$$

the collector current of transistor $T_6$ will vary substantially in the case of a small variation of the current I. Current stabilization is then achieved by controlling the current I by means of the collector current of transistor $T_6$; in the present case this is effected *via* a current mirror whose input circuit comprises a transistor $T_8$, arranged as a diode, in series with a resistor 9 and whose output circuit comprises the resistor 8 and the transistor $T_3$. As a result of this, the current I will be stabilized at a value

$$I=2\frac{KT}{qR}.$$

By connecting, for example an output 11 to the base of transistor $T_8$ a stabilized reference voltage will be available.

In order to obtain a maximum control range it is advantageous to offset the differential amplifier $T_4$, $T_5$ for a current I below the value

$$I=2\frac{KT}{qR},$$

*i.e.* for V=0 in Figure 2, so that transistor $T_6$ supplies a maximum current and in such a way that for $\Delta V=V_0$ (Figure 2) the differential amplifier is balanced. This is achieved by arranging resistors 16 and 7 between the resistors 1 and 2 and the associated collectors of transistors $T_1$ and $T_2$

and the associated base electrodes of transistors $T_4$ and $T_5$. The resistor 16 has such a larger value than resistor 7 that for equal currents through said resistors transistor $T_5$ carries the full current from the emitter-current source (10, 11, $T_7$). In a practical embodiment resistor 7 had a value 4R and resistor 6 a value 20R. Just before the bistable instant is reached for which

$$I=\frac{KT}{qR},$$

the input difference voltage of the differential amplifier is equal to

$$(21R-5R)\times \frac{KT}{qR} =16 \frac{KT}{q},$$

which is substantially equal to 400 mV. Moreover, resistors 16 and 7 provide an additional amplification for variations of I. The circuit arrangement shown in Figure 3 further comprises a transistor $T_9$ arranged as a capacitance between terminal 4 and terminal 3 in order to increase the stability of the arrangement.

The voltage-reference arrangement shown in Figure 3 is extremely suitable for very low supply voltages below 1.8 V and is capable of supplying reference voltages smaller than 1.1 V (on output 11).

## Claims

1. A current-discrimination arrangement having an input for receiving a current to be discriminated and an output, characterized in that the current discrimination arrangement comprises a first transistor ($T_1$) and a second transistor ($T_2$), each having a base electrode, an emitter electrode and a collector electrode, the collector electrode of the first transistor ($T_1$) being connected to a first point (3) *via* a first resistor (1) and the collector electrode of the second transistor ($T_2$) being connected to said first point (3) *via* a second resistor (2) of substantially the same value as the first resistor, the base electrode of the first transistor ($T_1$) being connected to a point between the second resistor (2) and the collector electrode of the second transistor ($T_2$), and the base electrode of the second transistor ($T_2$) to a point between the first resistor (1) and the collector electrode of the first transistor ($T_1$), the emitter electrodes of the first and second transistors being connected to a second point (6), the circuit between the first point (3) and the second point (6) being arranged in series with the input to receive the current to be discriminated, and the output (4, 5) being coupled to at least one of the two collector electrodes to provide an output voltage which, as a function of the input current of the arrangement, exhibits a steep transition when the arrangement reaches a bistable condition in which either the first or the second transistor is turned off.

2. A current-discrimination arrangement as claimed in Claim 1, characterized in that the output is a differential output between the collector electrodes (4, 5) of the first and second transistors.

3. A current-discrimination arrangement as claimed in Claim 1 or 2, characterized in that there are provided means for defining a preferred state of conduction for the two transistors in the input-current range for which the cross-coupled first and second transistors form a bistable circuit, in such a way that when said bistable condition is reached the first transistor ($T_1$) becomes more conductive and the second transistor ($T_2$) is cut off.

4. A current-discrimination arrangement as claimed in Claim 3 when appendant to Claim 2, characterized in that a third resistor (7) is arranged between the collector electrode of the first transistor ($T_1$) and the connection between the base electrode of the second transistor ($T_2$) and the first resistor (1), a fourth resistor (16) whose resistance is higher than the resistance of the third resistor (7) is arranged between the collector electrode of the second transistor ($T_2$) and the connection between the base electrode of the first transistor ($T_1$) and the second resistor (2), and the input of a differential amplifier ($T_4$, $T_5$) is connected to the connections between said third (7) and fourth resistors (16) and the collector electrodes of the first ($T_1$) and second transistors ($T_2$).

5. A current discrimination arrangement as claimed in Claim 4, characterized in that the differential amplifier comprises a third transistor ($T_4$) and a fourth transistor ($T_5$) with common emitter electrodes, the collector electrode of the third transistor ($T_4$) being connected substantially directly to the first point (3) and the collector electrode of the fourth transistor ($T_5$) being connected to the base electrode of a fifth transistor ($T_6$) whose emitter electrode is also connected to the first point (3), the base electrode of the third transistor ($T_4$) being connected to the collector electrode of the second transistor ($T_2$), and the base electrode of the fourth transistor ($T_5$) being connected to the collector electrode of the first transistor ($T_1$).

6. A current-discrimination arrangement as claimed in any of the Claims 1 to 5, characterized in that, in order to obtain a current stabilizing circuit, the output is coupled back to the input in such a way that the loop thus formed is stabilized at a point where the current in the current discrimination arrangement has reached such a value that the cross-coupled first and second transistors form a bistable circuit.

7. A current discrimination arrangement as claimed in Claim 6 when appendant to Claim 5, characterized in that the collector of the fifth transistor ($T_6$) is coupled to the second point (6) *via* a current mirror (8, 9, $T_3$, $T_8$) and the first point (3) is a point of fixed potential.

8. A current discrimination arrangement as claimed in Claim 7, characterized in that a capacitance ($T_9$) is arranged between the collector electrode of the second transistor ($T_2$) and the first point (3).

9. A current-stabilizing arrangement as claimed in Claim 7 or 8, characterized in that the current mirror comprises an input circuit which includes the series arrangement of a semiconductor junction ($T_8$) and a resistor (9), which series arrangement is connected to a reference-voltage output (11) on which a reference voltage for said series arrangement is available.

## Patentansprüche

1. Stromdiskriminationsanordnung mit einem Eingang für den Empfang eines zu diskriminierenden Stroms und mit einem Ausgang, dadurch gekennzeichnet, daß die Stromdiskriminationsanordnung einen ersten Transistor ($T_1$) und einen zweiten Transistor ($T_2$) mit je einer Basiselektrode, einer Emitterelektrode und einer Kollektorelektrode enthält, wobei die Kollektorelektrode des ersten Transistors ($T_1$) über einen ersten Widerstand (1) an einen ersten Punkt (3) und die Kollektorelektrode des zweiten Transistors ($T_2$) über einen zweiten Widerstand (2) mit dem im wesentlichen selben Wert des ersten Widerstands an den ersten Punkt (3) angeschlossen sind, wobei die Basiselektrode des ersten Transistors ($T_1$) an einen Punkt zwischen dem zweiten Widerstand (2) und der Kollektorelektrode des zweiten Transistors ($T_2$) und die Basiselektrode des zweiten Transistors ($T_2$) an einen Punkt zwischen dem ersten Widerstand (1) und der Kollektorelektrode des ersten Transistors ($T_1$) angeschlossen sind, und die Emitterelektroden des ersten und des zweiten Transistors an einen zweiten Punkt (6) angeschlossen sind, wobei die Schaltung zwischen dem ersten Punkt (3) und dem zweiten Punkt (6) für den Empfang des zu diskriminierenden Stroms mit dem Eingang in Reihe geschaltet und der Ausgang (4, 5) wenigstens mit einer der zwei Kollektorelektroden verbunden ist, um eine Ausgangsspannung zu liefern, die abhängig vom Eingangsstrom der Anordnung einen steilen Übergang zeigt, wenn die Anordnung einen bistabilen Zustand erreicht, in dem entweder der erste oder der zweite Transistor abgeschaltet ist.

2. Stromdiskriminationsanordnung nach Anspruch 1, dadurch gekennzeichnet, daß der Ausgang ein Differenzausgang zwischen den Kollektorelektroden (4, 5) des ersten und des zweiten Transistors ist.

3. Stromdiskriminationsanordnung nach Anspruch 1 oder 2, dadurch gekennzeichnet, daß Mittel zum Feststellen eines bevorzugten leitenden Zustands für die zwei Transistoren im Eingangsstrombereich, für den die kreuzweise gekoppelten ersten und zweiten Transistoren eine bistabile Schaltung bilden, derart vorgesehen sind, daß beim Eintreten des erwähnten bistabilen Zustands der erste Transistor ($T_1$) weiter aufgesteuert und der zweite Transistor ($T_2$) gesperrt wird.

4. Stromdiskriminationsanordnung nach Anspruch 3, wenn abhängig vom Anspruch 2, dadurch gekennzeichnet, daß ein dritter Widerstand (7) zwischen der Kollektorelektrode des ersten Transistors ($T_1$) und der Verbindung zwischen der Basiselektrode des zweiten Transistors ($T_2$) und dem ersten Widerstand (1), und ein vierter Widerstand (16), dessen Widerstandswert höher als der Widerstandswert des dritten Widerstands (7) ist, zwischen der Kollektorelektrode des zweiten Transistors ($T_2$) und der Verbindung zwischen der Basiselektrode des ersten Transistors ($T_1$) und dem zweiten Widerstand (2) vorgesehen ist, und der Eingang eines Differenzverstärkers ($T_4$, $T_5$) an die Verbindungen zwischen dem dritten (7) und dem vierten Widerstand (16) und den Kollektorelektroden des ersten ($T_1$) und des zweiten Transistors ($T_2$) angeschlossen ist.

5. Stromdiskriminationsanordnung nach Anspruch 4, dadurch gekennzeichnet, daß der Differenzverstärker einen dritten ($T_4$) und einen vierten Transistor ($T_5$) mit gemeinsamen Emitterelektroden enthält, wobei die Kollektorelektrode des dritten Transistors ($T_4$) im wesentlichen mit dem ersten Punkt (3) direkt verbunden ist, und die Kollektorelektrode des vierten Transistors ($T_5$) an die Basiselektrode eines fünften Transistors ($T_6$) angeschlossen ist, dessen Emitterelektrode ebenfalls mit dem ersten Punkt (3) verbunden ist, und wobei die Basiselektrode des dritten Transistors ($T_4$) an die Kollektorelektrode des zweiten Transistors ($T_2$) und die Basiselektrode des vierten Transistors ($T_5$) an die Kollektorelektrode des ersten Transistors ($T_1$) angeschlossen sind.

6. Stromdiskriminationsanordnung nach einem oder mehreren der Ansprüche 1 bis 5, dadurch gekennzeichnet, daß zur Bildung einer Stromstabilisationsschaltung der Ausgang derart zum Eingang rückgekoppelt ist, daß die auf diese Weise gebildete Schleife an einem Punkt stabilisiert wird, an dem der Strom in der Stromdiskriminationsanordnung einen derartigen Wert erreicht hat, daß die kreuzweise gekoppelten ersten und zweiten Transistoren eine bistabile Schaltung bilden.

7. Stromdiskriminationsanordnung nach Anspruch 6, wenn abhängig vom Anspruch 5, dadurch gekennzeichnet, daß der Kollektor des fünften Transistors ($T_6$) über einen Stromspiegel (8, 9, $T_3$, $T_8$) mit dem zweiten Punkt (6) verbunden ist und der erste Punkt (3) ein Punkt mit festem Potential ist.

8. Stromdiskriminationsanordnung nach Anspruch 7, dadurch gekennzeichnet, daß eine Kapazität ($T_9$) zwischen der Kollektorelektrode des zweiten Transistors ($T_2$) und dem ersten Punkt (3) angeordnet ist.

9. Stromstabilisationsanordnung nach Anspruch 7 oder 8, dadurch gekennzeichnet, daß der Stromspiegel eine Eingangsschaltung enthält, die die Reihenschaltung aus einem Halbleiterübergang ($T_8$) und einem Widerstand (9) einschließt, und diese Reihenschaltung an einen Bezugsspannungsausgang angeschlossen ist, an dem eine Bezugsspannung für die Reihenschaltung zur Verfügung steht.

## Revendications

1. Dispositif discriminateur de courant muni d'une entrée pour recevoir un courant à discriminer et d'une sortie, caractérisé en ce que le dispositif discriminateur de courant comprend un premier transistor ($T_1$) et un deuxième transistor ($T_2$), chacun muni d'une électrode de base, d'une électrode d'émetteur et d'une électrode de collecteur, l'électrode de collecteur du premier transistor ($T_1$) étant connectée à un premier point (3) par l'intermédiaire d'une première résistance (1) et l'électrode de collecteur du deuxième transistor ($T_2$) étant connectée audit premier point (3) par l'intermédiaire d'une deuxième résistance (2) présentant pratiquement la même valeur que la première résistance, l'électrode de base du premier transistor ($T_1$) étant connectée à un point situé entre la deuxième résistance (2) et l'électrode de collecteur du deuxième transistor ($T_2$), et l'électrode de base du deuxième transistor ($T_2$) étant connectée à un point situé entre la première résistance (1) et l'électrode de collecteur du premier transistor ($T_1$), les électrodes d'émetteur des premier et deuxième transistors étant connectées à un deuxième point (6), le circuit entre le premier point (3) et le deuxième point (6) étant monté en série avec l'entrée pour recevoir le courant à discriminer, et la sortie (4, 5) étant couplée à au moins l'une des deux électrodes de collecteur afin de fournir une tension de sortie qui, en fonction du courant d'entrée du montage, présente une transition rapide lorsque le montage atteint une condition bistable dans laquelle soit le premier transistor soit le deuxième transistor est mis hors service.

2. Dispositif discriminateur de courant selon la revendication 1, caractérisé en ce que la sortie est une sortie différentielle entre les électrodes collecteur (4, 5) des premier et deuxième transistors.

3. Dispositif discriminateur de courant selon la revendication 1 ou 2, caractérisé en ce qu'on a prévu des moyens pour définir un état préféré de la conduction pour les deux transistors dans la gamme de courant d'entrée pour laquelle les premier et deuxième transistors couplés de façon croisée un circuit bistable de telle façon que lorsque ladite condition bistable est atteinte, le premier transistor devienne plus conducteur et le deuxième transistor soit bloqué.

4. Dispositif discriminateur de courant selon la revendication 3, en dépendance de la revendication 2, caractérisé en ce qu'une troisième résistance (7) est montée entre l'électrode de collecteur du premier transistor ($T_1$) et la connexion entre l'électrode de base du deuxième transistor ($T_2$) et la première résistance (1), une quatrième résistance (16) dont la valeur de résistance est supérieure à la résistance de la troisième résistance (7) est montée entre l'électrode de collecteur du deuxième transistor ($T_2$) et la connexion entre l'électrode de base du premier transistor ($T_1$) et la deuxième résistance (2) et l'entrée d'un amplificateur différentiel ($T_4$, $T_5$) est connectée aux connexions entre lesdites troisième (7) et quatrième résistances (16) et les électrodes de collecteur des premier ($T_1$) et deuxième transistors ($T_2$).

5. Dispositif discriminateur de courant selon la revendication 4, caractérisé en ce que l'amplificateur différentiel comprend un troisième transistor ($T_4$) et un quatrième transistor ($T_5$) munis d'électrodes d'émetteur communes, l'électrode de collecteur du troisième transistor ($T_4$) étant connectée d'une façon pratiquement directe au premier point (3) et l'électrode de collecteur du quatrième transistor ($T_5$) étant connectée à l'électrode de base d'un cinquième transistor ($T_6$) dont l'électrode d'émetteur est également connectée au premier point (B), l'électrode de base du troisième transistor ($T_4$) étant connectée à l'électrode de collecteur du deuxième transistor ($T_2$) et l'électrode de base du quatrième transistor ($T_5$) étant connectée à l'électrode de collecteur du premier transistor ($T_1$).

6. Dispositif discriminateur de courant selon l'une des revendications 1 à 5, caractérisé en ce que pour obtenir un circuit de stabilisation de courant, la sortie, a été rétrocouplée à l'entrée de façon que la boucle ainsi formée soit stabilisée à un point où le courant dans le dispositif discriminateur de courant a atteint une valeur telle que les premier et deuxième transistors couplés de façon croisée constituent en circuit bistable.

7. Dispositif discriminateur de courant selon la revendication 6, en dépendance de la revendication 5, caractérisé en ce que le collecteur du cinquième transistor ($T_6$) est couplé au deuxième point (6) par l'intermédiaire d'un miroir de courant (8, 9, $T_3$, $T_8$) et le premier point (3) est un point de potentiel fixe.

8. Dispositif discriminateur de courant selon la revendication 7, caractérisé en ce qu'un condensateur ($T_9$) est disposé entre l'électrode de collecteur du deuxième transistor ($T_2$) et le premier point (3).

9. Dispositif stabilisateur de courant selon la revendication 7 ou 8, caractérisé en ce que le miroir de courant présente un circuit d'entrée qui comprend le montage en série d'une jonction semiconductrice ($T_8$) et d'une résistance (9), montage en série qui est connecté à une sortie de tension de référence (11) à laquelle est disponible une tension de référence pour ledit montage en série.

FIG.1

FIG.2

FIG.3